# EUROPEAN PATENT APPLICATION

(11) **EP 4 786 993 A1**
(43) Date of publication of application: **05.08.2026**
(21) Application number: 25873833.5
(22) Date of filing: 12.08.2025
(51) Int. Cl.: G01R 31/382, G01R 31/36, G01R 1/30, G08C 23/04, H01M 10/48

(54) **SIGNAL OUTPUT DEVICE AND BATTERY SYSTEM INCLUDING SAME**

(30) Priority: 24.09.2024 KR 20240128631
(71) Applicant: LG Energy Solution, Ltd., Seoul 07335 (KR)
(72) Inventor: LEE, Muyeon, Daejeon 34122 (KR)
(74) Representative: BCKIP Part mbB
(86) International application number: PCT/KR2025/012181
(87) International publication number: WO 2026/071471

(57) **Abstract**

A signal output device according to an embodiment of the present invention may comprise: a contact connected to an external device; a control unit for outputting a signal to be transmitted to the external device; and a signal transmission circuit for transmitting the signal output from the control unit to the contact. Here, the control unit may control the signal transmission circuit to allow the contact to operate as either a dry contact or a wet contact.

## Description

### [Technical Field]

This application claims priority to and the benefit of Korean Patent Application No.10-2024-0128631 filed in the Korean Intellectual Property Office on September 24, 2024 the entire contents of which are incorporated herein by reference.

The present invention relates to a signal output apparatus and a battery system including the signal output apparatus, and more particularly, to a signal output apparatus outputting a certain signal to an external device via a contact and a battery system including the signal output apparatus.

### [Background Art]

Secondary batteries, capable of recharging and reuse, may be used as an energy source for small devices such as mobile phones, tablet PCs and vacuum cleaners, and also used as an energy source for medium and large devices such as automobiles and an energy storage system (ESS) for smart grids.

Secondary batteries may be applied to a system in a form of an assembly such as a battery pack in which multiple battery cells are electrically connected or a battery rack in which battery packs are electrically connected according to system requirements. For an ESS for smart grids, a high-capacity battery system with a plurality of battery racks connected in parallel can be applied to satisfy required capacity of the system.

During battery system operation, a battery system needs to transmit specific signals (e.g., a signal indicating that the battery system is in normal state) to the device to which the battery system is applied. The battery system and the device are connected through contacts for transmission of these signals and the battery system can transmit the signals to the device through these contacts.

Depending on the design requirements of the device to which the battery system is applied, the contacts for signal transmission must be designed as either dry contacts or wet contacts.

Generally, battery systems are not individually designed to reflect the requirements of each device, but rather designed to be applicable to a variety of devices to reduce design and manufacturing costs. However, if a battery system is manufactured according to a design to which a specific type of contact is reflected during design of the battery system, the battery system cannot be applied to devices that require a different type of contact.

Among the prior art documents relevant to the present invention, CN 214310843 U is of some relevance.

### [Detailed Description of the Invention]

### [Technical Problem]

To obviate one or more problems of the related art, embodiments of the present disclosure provide a signal output apparatus capable of changing the type of contact that outputs a signal to a device.

To obviate one or more problems of the related art, embodiments of the present disclosure also provide a battery system including the signal output apparatus.

### [Technical Solution]

In order to achieve the objective of the present disclosure, a signal output apparatus may include a contact connected to an external device; a controller configured to output a signal to be transmitted to the external device; and a signal transmission circuit configured to transmit the signal output from the controller to the contact. Here, the controller may control the signal transmission circuit to cause the contact to operate as either a dry contact or a wet contact.

The signal transmission circuit may include a first signal transmission circuit configured to transmit a signal output from the controller to the contact in an optical transmission manner; and a second signal transmission circuit configured to transmit power output from a power supplier to the contact together with the signal output from the controller.

The controller may output a signal to be transmitted to the external device to only one of the first signal transmission circuit and the second signal transmission circuit.

The first signal transmission circuit may include a first power supply line, one end of which is connected to the power supplier and the other end is grounded; a light-emitting element disposed on the first power supply line; a first switch disposed on the first power supply line; a first control terminal for controlling the on/off operation of the first switch; and a light-receiving element connected to the contact.

The controller may output a signal to be transmitted to the external device to the first control terminal, thereby causing the contact to operate as a dry contact.

The first signal transmission circuit may, upon a signal being input from the controller to the first control terminal, transmits the signal to the contact via the light-emitting element and the light-receiving element.

The second signal transmission circuit may include a second power supply line, one end of which is connected to the power supplier and the other end is connected to the first terminal of the contact; a ground line, one end of which is connected to the second terminal of the contact and the other end is grounded; a second switch disposed on the second power supply line; a second control terminal for controlling the on/off operation of the second switch; a third switch disposed on the ground line; and a third control terminal for controlling the on/off operation of the third switch.

The controller may output a signal to be transmitted to the external device to the second control terminal and the third control terminal, thereby causing the contact to operate as a wet contact.

The second signal transmission circuit may, upon a signal being input from the controller to the second control terminal and the third control terminal, transmit the signal and power output from the power supplier together to the contact.

The controller may cause the contact to operate as either a dry contact or a wet contact according to a contact type required by the external device.

According to another embodiment of the present disclosure, a battery system may include a battery; and a signal output apparatus configured to output a signal associated with the battery to an external device. Here, the signal output apparatus may include a contact connected to the external device; a controller configured to output a signal to be transmitted to the external device; and a signal transmission circuit configured to transmit the signal output from the controller to the contact.

The controller may control the signal transmission circuit to cause the contact to operate as either a dry contact or a wet contact.

The signal output apparatus may be included in a battery management system (BMS) of the battery system.

### [Advantageous Effects]

According to embodiments of the present disclosure, it is possible to output a signal corresponding to the type of contact required by the device, thereby reducing the design and manufacturing cost of the battery system.

### [Brief Description of the Drawings]

FIG. 1 is a block diagram of a general energy storage system.
FIG. 2 illustrates a structure of a general battery rack.
FIG. 3 is a block diagram of a battery system according to embodiments of the present invention.
FIG. 4 is a circuit diagram of a signal output apparatus according to embodiments of the present invention.
FIG. 5 is a diagram illustrating the operation of a signal output apparatus in dry contact mode.
FIG. 6 is a diagram illustrating the operation of a signal output apparatus in wet contact mode.

10: battery system
20: external device
100: battery
200: power supplier
300: signal output apparatus
310: controller
320: signal transmission circuit

### [Best Modes for Practicing the Disclosure]

The present invention may be modified in various forms and have various embodiments, and specific embodiments thereof are shown by way of example in the drawings and will be described in detail below. It should be understood, however, that there is no intent to limit the present invention to the specific embodiments, but on the contrary, the present invention is to cover all modifications, equivalents, and alternatives falling within the spirit and technical scope of the present invention. Like reference numerals refer to like elements throughout the description of the figures.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes combinations of a plurality of associated listed items or any of the plurality of associated listed items.

It will be understood that when an element is referred to as being "coupled" or "connected" to another element, it can be directly coupled or connected to the other element or an intervening element may be present. In contrast, when an element is referred to as being "directly coupled" or "directly connected" to another element, there is no intervening element present.

The terms used herein is for the purpose of describing specific embodiments only and are not intended to limit the present invention. As used herein, the singular forms "a", "an" and "the" are intended to include the plural forms as well, unless the context clearly indicates otherwise. It will be further understood that the terms "includes", "comprising", "includes", "including" and/or "having", when used herein, specify the presence of stated features, integers, steps, operations, constitutional elements, components and/or combinations thereof, but do not preclude the presence or addition of one or more other features, integers, steps, operations, constitutional elements, components, and/or combinations thereof.

Unless otherwise defined, all terms used herein, including technical and scientific terms, have the same meanings as commonly understood by one skilled in the art to which the present invention belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

Some terms used herein are defined as follows.

A battery cell is a basic unit that serves to store power and a battery module refers to an assembly in which a plurality of battery cells is electrically connected.

A battery rack may refer to a system of a single structure which is assembled by connecting modules set by a battery manufacturer in series/parallel and can be monitored and controlled by a battery management system (BMS). A battery rack may include several battery modules and a battery protection unit or any other protection device. Here, the battery module may also be referred to as a battery pack depending on a device or system in which the battery is used.

A battery bank refers to a group of large-scale battery rack systems configured by connecting a plurality of battery racks in parallel. A bank BMS for a battery bank may monitor and control several rack BMSs, each of which manages a battery rack.

A battery assembly may include a plurality of electrically connected battery cells, and refers to an assembly that functions as a power supply source by being applied to a specific system or device. Here, the battery assembly may mean a battery module, a battery pack, a battery rack, or a battery bank, but the scope of the present invention is not limited to these entities.

A battery system controller (BSC) may refer to an apparatus that controls the topmost level of a battery system including a battery bank level structure and may also be used as a controller in a battery system with a multiple bank-level structure.

State of Charge (SOC) refers to a current state of charge of a battery, represented in percent points [%], and State of Health (SOH) refers to a current condition of a battery compared to its ideal or original conditions, represented in percent points [%].

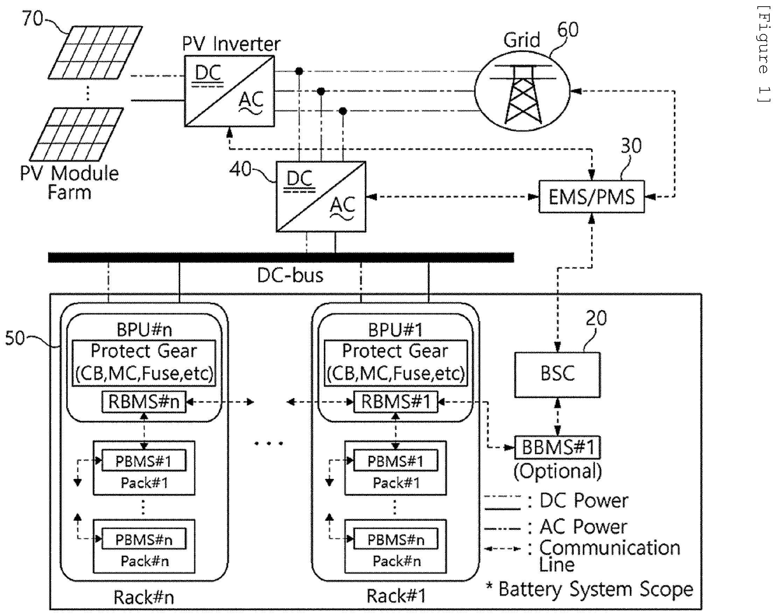

FIG. 1 is a block diagram of a general energy storage system.

Typically, a battery cell is a basic unit of battery for storing power in an energy storage system (ESS). A seris/parallel combination of battery cells may form a battery pack and a plurality of battery packs may form a battery rack. In other words, a battery rack as a series/parallel combination of battery packs may be a basic unit of a battery system. Here, a battery pack may be referred to as a battery module depending on a device or a system in which the battery is used.

Referring to FIG. 1, a battery rack may include a plurality of battery packs and a battery protection unit (BPU) 50 or protection device. A battery rack may be monitored and controlled through a rack battery management system (rack BMS). The RBMS may monitor a current, a voltage and a temperature of each battery rack to be managed, calculate a state Of charge (SOC) of the battery based on a monitoring result, and control charging and discharging.

Meanwhile, the BPU 50 is a device for protecting the battery from abnormal current and fault current in a battery rack. The BPU may include a main contactor MC, a fuse, a circuit breaker CB, or a disconnect switch DS. The BPU may control the battery system rack by rack by controlling the main contactor on/off according to control of the RBMS. The BPU may also protect the battery from short-circuit current by using a fuse when a short-circuit occurs. As such, a general battery system may be controlled through a protection device such as a BPU or a switch gear.

Meanwhile, a battery system controller (BSC) 20 may be installed to monitor and control objects such as a voltage, a current, a temperature, and a circuit breaker, in each battery section including a plurality of batteries, peripheral circuits, and devices. The battery system controller is a top-level controller of a bank-level battery system including a plurality of battery racks and is also used as a controller in a battery system with a multiple bank-level structure. Here, a bank-level battery system may each include a Bank BMS (BBMS), and the BBMS may monitor and control each rack by interfacing with the RBMSs of the battery racks to be managed.

Furthermore, a power conversion system (PCS) 40 installed in each battery section controls charging and discharging of the battery by controlling power supplied from an external source and power supplied from the battery section to the external, and may include a DC/AC inverter. Meanwhile, if the ESS system is interfacing with a photovoltaic (PV) module farm 70, a PV inverter may be included.

Meanwhile, the output of each BPU may be connected to the PCS 40 which is connected to a power grid 60, through a DC bus. In addition, an energy management system (EMS)/power management system (PMS) 30 may control the energy storage system in overall.

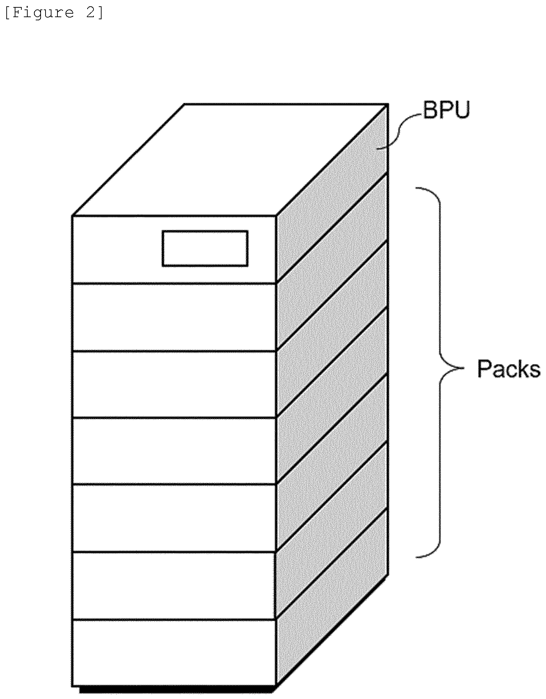

FIG. 2 illustrates a structure of a general battery rack.

The battery rack may include a battery protection unit (BPU) and a plurality of battery packs. Here, the BPU and the plurality of battery packs may be combined in a vertically stacked structure.

The BPU, located at the top of the battery rack, may include a circuit breaker (CB) and a rack BMS (RBMS).

The RBMS may include a main contactor MC, a fuse, a microcontroller unit (MCU), memory, a power supplier, and a current sensor.

Each of the battery packs positioned below the BPU may include a plurality of batteries and a pack battery management system (PBMS) that monitors and manages the batteries.

The batteries within each battery pack may be electrically connected in series and/or parallel and connected to power terminals provided in the BPU, thereby connecting to a direct current (DC) link.

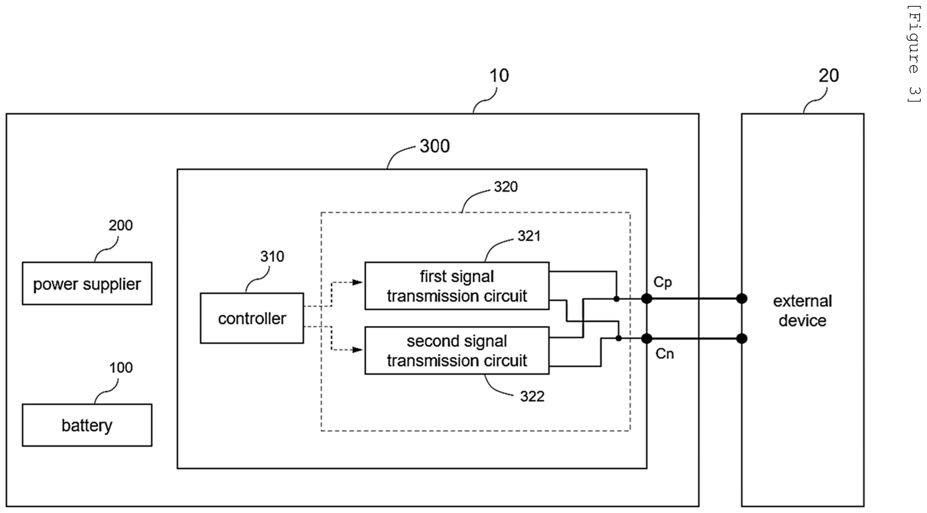

FIG. 3 is a block diagram of a battery system according to embodiments of the present invention.

Referring to FIG. 3, the battery system 10 may be connected to an external device 20 via contact Cp, Cn. Here, the battery system 10 may output a specific signal to the external device 20 via the contact Cp, Cn.

The battery system 10 may include a battery 100, a power supplier 200, and a signal output apparatus 300.

The battery 100 may refer to a battery cell, a battery module, a battery pack, a battery rack, or a battery bank.

The power supplier 200 may supply power to the signal output apparatus 300. For example, the power supplier 200 may be a Switching Mode Power Supply (SMPS) that receives power from the battery 100 and supplies a determined voltage to a battery management system (BMS). Here, the SMPS may be configured to supply power to a signal output apparatus 300 included within the BMS.

The signal output apparatus 300 may output a signal associated with the battery 100 to the external device 20. The signal output to the external device 20 may **conform** to a protocol required by the external device 20. For example, the signal output apparatus 300 may output a signal of a predefined pulse waveform to the external device 20 at determined time intervals to indicate that the battery is in a normal state.

The signal output apparatus 300 may include a controller 310 and a signal transmission circuit 320.

The controller 310 may output a signal to be transmitted to the external device 20. The controller 310 may be a Micro Controller Unit (MCU) included in the BMS of the battery system.

The signal transmission circuit 320 may transmit a signal output from the controller 310 to the contact Cp, Cn.

The controller 310 may control the signal transmission circuit 320 to cause the contact Cp, Cn to operate as either a dry contact or wet contact.

If the contact Cp, Cn operate as a wet contact, the power output from the power supplier 200 together with the signal output from the controller 310 may be transmitted to the external device 20. Conversely, if the contact Cp, Cn operate as dry contacts, only the signal output from the controller 310 may be transferred to the external device 20.

The signal transmission circuit 320 may include a first signal transmission circuit 321 and a second signal transmission circuit 322.

The first signal transmission circuit 321 may transmit a signal output from the controller 310 to the contact Cp, Cn in an optical transmission manner. In addition, the second signal transmission circuit 322 may transmit power output from the power supplier 200 together with a signal output from the controller 310 to the contact Cp, Cn.

The controller 310 may output a signal to be transmitted to an external device to only one of the first signal transmission circuit 321 and the second signal transmission circuit 322. If the controller 310 outputs a signal to the first signal transmission circuit 321, the signal may be transmitted to the contact Cp, Cn in an optical transmission manner, so that the contact Cp, Cn function as a dry contact. In contrast, when the controller 310 outputs a signal to the second signal transmission circuit 322, the power output from the power supplier 200 may be transmitted to the contact Cp, Cn along with the signal, so that the contact Cp, Cn function as a wet contact.

The controller 310 may cause the contact Cp, Cn to operate as either a dry contact or a wet contact, depending on the contact type required by the external device 20. For example, when the contact type required by the external device 20 is a dry contact, the controller 310 may transmit the signal to the contact Cp, Cn using the first signal transmission circuit 321. In another example, when the contact type required by the external device 20 is a wet contact, the controller 310 may transmit the signal and power to the contact Cp, Cn using the second signal transmission circuit 322.

The contact type required by the external device 20 may be stored in a storage device or memory included in the battery system before the signal output apparatus 300 is connected to the external device 20.

The controller 310 may identify the contact type stored in the storage device or memory and, depending on the identified contact type, cause the signal output apparatus 300 to operate in either dry contact mode or wet contact mode.

The signal output apparatus 300 may be incorporated into the BMS included in the battery system. For example, the controller 310 may be an MCU included in the BMS, and the signal output apparatus 300 may be implemented on the circuit board of the BMS.

Meanwhile, unlike that illustrated in FIG. 3, the signal output apparatus 300 may be applied to various systems other than the battery system 10. Specifically, the signal output apparatus 300 according to embodiments of the present invention can be applied to any device that is connected to an external device and requires the output of a specific signal to the external device.

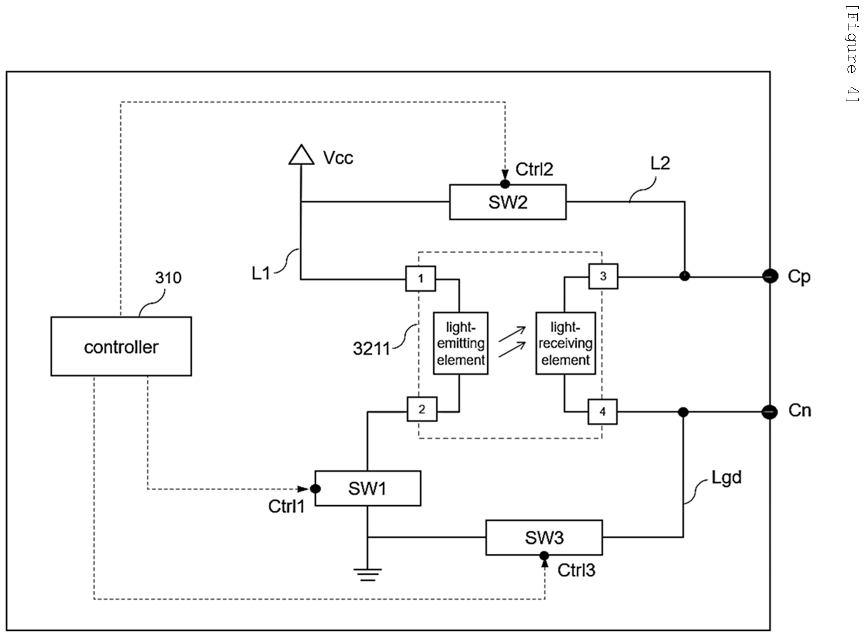

FIG. 4 is a circuit diagram of a signal output apparatus according to embodiments of the present invention.

Referring to FIG. 4, the signal output apparatus may include a controller 310 and a signal transmission circuit. Here, the signal transmission circuit may include a first signal transmission circuit and a second signal transmission circuit.

The first signal transmission circuit may include a first power supply line L1, a light-emitting element, a light-receiving element, and a first switch SW1.

Specifically, one end of the first power supply line L1 may be connected to a power supplier Vcc, and the other end of the first power supply line L1 may be grounded. Furthermore, the light-emitting element and the first switch SW1 may be positioned on the first power supply line L1. One end of the light-receiving element may be connected to a first terminal Cp of a contact and the other end of the light-receiving element may be connected to a second terminal Cn of the contact.

The light-emitting element and the light-receiving element may be included in a photo relay 3211. Here, the photo relay 3211 may include a first input terminal 1, a second input terminal 2, a first output terminal 3, and a second output terminal 4.

A light-emitting element may be positioned between the first input terminal 1 and the second input terminal 2, and a light-receiving element may be positioned between the first output terminal 3 and the second output terminal 4.

The first input terminal 1 may be connected to a power supplier Vcc, and the second input terminal 2 may be connected to a ground line where a first switch SW1 is positioned. Furthermore, the first output terminal 3 may be connected to a first terminal Cp of a contact, and the second output terminal 4 may be connected to a second terminal Cn of the contact.

The first switch SW1 may include a first control terminal (Ctrl 1) and be turned on and off by a signal input to the first control terminal (Ctrl 1). For example, the first switch SW1 may be implemented as a Field Effect Transistor (FET), and the first control terminal (Ctrl 1) may be a gate terminal or a base terminal.

The second signal transmission circuit may include a second power supply line L2, a ground line Lgd, a second switch SW2, and a third switch SW3.

Specifically, one end of the second power supply line L2 may be connected to a power supplier Vcc, and the other end of the second power supply line L2 may be connected to the first terminal Cp of the contact. Furthermore, the second switch SW2 may be positioned on the second power supply line L2.

One side of the ground line Lgd is connected to the second terminal Cn of the contact and the other side of the ground line Lgd may be grounded. In addition, a third switch SW3 may be disposed on the ground line Lgd.

The second switch SW2 may include a second control terminal (Ctrl 2) and be turned on and off by a signal input to the second control terminal (Ctrl 2). In addition, the third switch SW3 may include a third control terminal (Ctrl 3) and be turned on and off by a signal input to the third control terminal (Ctrl 3). For example, the second switch SW2 and the third switch SW3 may be implemented as FETs, and the second control terminal (Ctrl 2) and the third control terminal (Ctrl 3) may be a gate terminal or a base terminal.

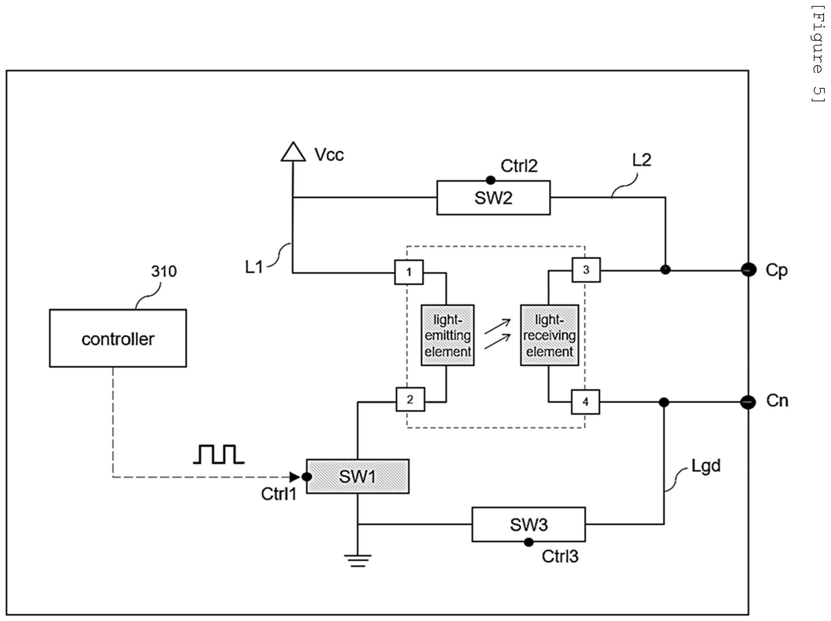

FIG. 5 is a diagram illustrating the operation of a signal output apparatus in dry contact mode.

If the contact type requested by the external device 20 is a dry contact, the controller 310 may cause the signal output apparatus 300 to operate in dry contact mode.

In dry contact mode, the controller 310 may transmit a signal to the contact Cp, Cn using the first signal transmission circuit.

Specifically, the controller 310 may output a signal to be transmitted to the external device to the first control terminal (Ctrl 1), thereby causing the contact Cp, Cn to operate as dry contact. Here, when a signal is input from the controller 310 to the first control terminal (Ctrl 1), the first signal transmission circuit may transmit the input signal to the contact Cp, Cn through optical transmission via a light-emitting element and a light-receiving element.

For example, as illustrated in FIG. 5, when the controller 310 outputs a pulse waveform signal to the first control terminal (Ctrl 1), the first switch SW1 may be turned on and off according to the pulse waveform signal. The light-emitting element may emit light by receiving an operating voltage from the power supplier Vcc in the ON (closed) state of the first switch SW1. Accordingly, the pulse waveform signal output by the controller 310 may be transmitted to the light-receiving element side, i.e., the contact Cp, Cn, in an optical transmission manner.

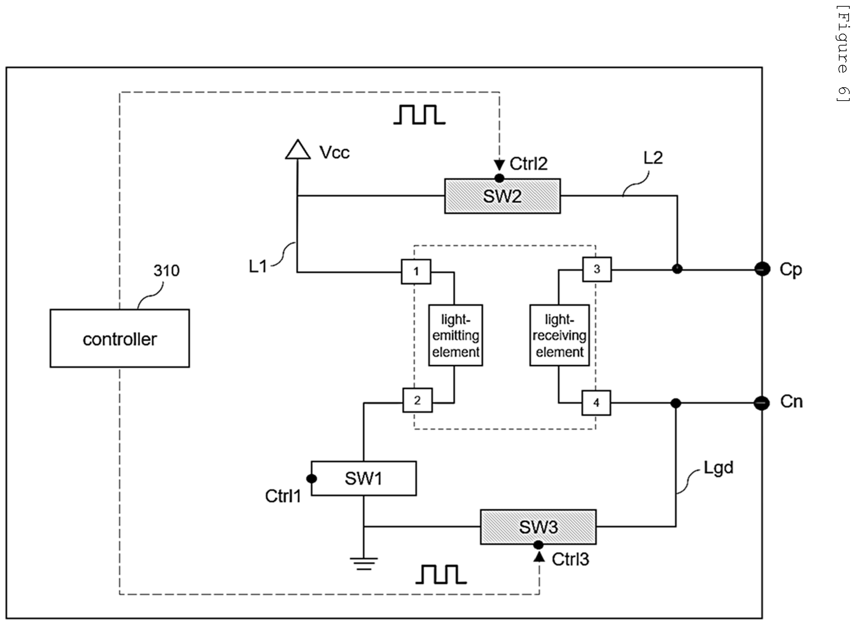

FIG. 6 is a diagram illustrating the operation of a signal output apparatus in wet contact mode.

If the contact type requested by the external device 20 is a wet contact, the controller 310 may cause the signal output apparatus 300 to operate in wet contact mode.

In wet contact mode, the controller 310 may transmit power and signals to the contact Cp, Cn using the second signal transmission circuit.

Specifically, the controller 310 may output a signal to be transmitted to the external device to the second control terminal (Ctrl 2) and the third control terminal (Ctrl 3), thereby causing the contact Cp, Cn to operate as wet contact. Here, the second signal transmission circuit may transmit the input signal and the power output from the power supplier (Vcc) to the contact Cp, Cn when a signal is input from the controller 310 to the second control terminal (Ctrl 2) and the third control terminal (Ctrl 3).

For example, as illustrated in FIG. 6, when the controller 310 outputs a pulse waveform signal to the second control terminal (Ctrl 2) and the third control terminal (Ctrl 3), the second switch SW2 and the third switch SW3 may be turned on and off according to the pulse waveform signal. When the second switch SW2 and the third switch SW3 are in the ON (closed) state, voltage is applied to the first terminal Cp of the contact by the power output from the power supplier (Vcc) and the second terminal Cn of the contact is grounded. Accordingly, a voltage corresponding to the pulse waveform signal output by the controller 310 may be applied to both ends of the contact Cp, Cn.

In the forgoing, the present invention has been described with reference to the exemplary embodiment of the present invention, but those skilled in the art may appreciate that the present invention may be variously corrected and changed within the range without departing from the spirit and the area of the present invention described in the appending claims.

## Claims

1. A signal output apparatus comprising:
a contact connected to an external device;
a controller configured to output a signal to be transmitted to the external device; and
a signal transmission circuit configured to transmit the signal output from the controller to the contact,
wherein the controller controls the signal transmission circuit to cause the contact to operate as either a dry contact or a wet contact.

2. The apparatus of claim 1, wherein the signal transmission circuit includes:
a first signal transmission circuit configured to transmit a signal output from the controller to the contact in an optical transmission manner; and
a second signal transmission circuit configured to transmit power output from a power supplier to the contact together with the signal output from the controller.

3. The apparatus of claim 2, wherein the controller outputs a signal to be transmitted to the external device to only one of the first signal transmission circuit and the second signal transmission circuit.

4. The apparatus of claim 2, wherein the first signal transmission circuit includes:
a first power supply line, one end of which is connected to the power supplier and the other end is grounded;
a light-emitting element disposed on the first power supply line;
a first switch disposed on the first power supply line;
a first control terminal for controlling the on/off operation of the first switch; and
a light-receiving element connected to the contact.

5. The apparatus of claim 4, wherein the controller outputs a signal to be transmitted to the external device to the first control terminal, thereby causing the contact to operate as a dry contact.

6. The apparatus of claim 4, wherein the first signal transmission circuit, upon a signal being input from the controller to the first control terminal, transmits the signal to the contact via the light-emitting element and the light-receiving element.

7. The apparatus of claim 2, wherein the second signal transmission circuit includes:
a second power supply line, one end of which is connected to the power supplier and the other end is connected to the first terminal of the contact;
a ground line, one end of which is connected to the second terminal of the contact and the other end is grounded;
a second switch disposed on the second power supply line;
a second control terminal for controlling the on/off operation of the second switch;
a third switch disposed on the ground line; and
a third control terminal for controlling the on/off operation of the third switch.

8. The apparatus of claim 7, wherein the controller outputs a signal to be transmitted to the external device to the second control terminal and the third control terminal, thereby causing the contact to operate as a wet contact.

9. The apparatus of claim 7, wherein the second signal transmission circuit, upon a signal being input from the controller to the second control terminal and the third control terminal, transmits the signal and power output from the power supplier together to the contact.

10. The apparatus of claim 1, wherein the controller causes the contact to operate as either a dry contact or a wet contact according to a contact type required by the external device.

11. A battery system comprising:
a battery; and
a signal output apparatus configured to output a signal associated with the battery to an external device,
wherein the signal output apparatus includes:
a contact connected to the external device;
a controller configured to output a signal to be transmitted to the external device; and
a signal transmission circuit configured to transmit the signal output from the controller to the contact,
wherein the controller controls the signal transmission circuit to cause the contact to operate as either a dry contact or a wet contact.

12. The system of claim 11, wherein the signal output apparatus is included in a battery management system (BMS) of the battery system.
